# EUROPEAN PATENT APPLICATION

(11) **EP 4 770 309 A1**
(43) Date of publication of application: **01.07.2026**
(21) Application number: 25791169.3
(22) Date of filing: 16.01.2025
(51) Int. Cl.: H10B 12/00

(54) **MEMORY AND MANUFACTURING METHOD THEREFOR, AND ELECTRONIC DEVICE**

(30) Priority: 19.08.2024 CN 202411140980
(71) Applicant: CXMT Corporation, Hefei, Anhui 230601 (CN)
(72) Inventor: DENG, Fangxin, Hefei, Anhui 230601 (CN); DU, Guoan, Hefei, Anhui 230601 (CN); GUO, Donglong, Hefei, Anhui 230601 (CN); LEI, Jiang, Hefei, Anhui 230601 (CN); JIN, Yushan, Hefei, Anhui 230601 (CN)
(74) Representative: Gulde & Partner
(86) International application number: PCT/CN2025/072711
(87) International publication number: WO 2026/040311

(57) **Abstract**

A memory and a manufacturing method therefor, and an electronic device are provided. The memory includes a first semiconductor structure. The first semiconductor structure includes an active pillar row, a word line, a data storage element, and a first contact plug. The active pillar row includes multiple active pillars extending in a first direction and arranged in a second direction. The multiple active pillars include a first active pillar located in a first region and a second active pillar located in a second region. The second region is located on at least one side of the first region in the second direction, and the second direction is perpendicular to the first direction. The word line extends in the first region and the second region in the second direction, and is coupled to the multiple active pillars in the active pillar row. The data storage element is located on a first side of the first active pillar in the first direction and is coupled to the first active pillar. The first contact plug is located in the second region and is coupled to the word line. An orthographic projection of the first contact plug in the first direction overlaps with an orthographic projection of the second active pillar in the first direction.

## Description

This application is based on and claims priority of the Chinese Patent Application No. 202411140980.5, filed with China National Intellectual Property Administration on August 19, 2024 and entitled "MEMORY AND MANUFACTURING METHOD THEREFOR, AND ELECTRONIC DEVICE". The above-referenced application is incorporated herein by reference in its entirety.

### TECHNICAL FIELD

The embodiments of the present disclosure relate to the field of semiconductor technologies, and in particular, to a memory and a manufacturing method therefor, and an electronic device.

### BACKGROUND

A dynamic random access memory (Dynamic Random Access Memory, DRAM) is a semiconductor memory. Compared with a static memory, the DRAM has advantages such as a simple structure, low manufacturing costs, and high storage density. With the development of technologies, the DRAM has found increasingly widespread applications. The DRAM includes multiple storage elements. Each of the storage elements includes a transistor and a capacitor. The source of the transistor is connected to a bit line, the drain of the transistor is connected to the capacitor, and the gate of the transistor is connected to a word line. The transistor stores data information of the bit line in the capacitor under the control of the word line, or reads data information stored in the capacitor through the bit line.

With the development of semiconductor technologies, an architecture solution is provided for changing a planar transistor in the DRAM to a vertical transistor (also referred to as a vertical channel transistor whose channel extends at least partially in the vertical direction). In this architecture, a vertically extending active pillar is formed on a substrate, and a gate is formed on a side surface of the active pillar. However, the DRAM with the vertical transistor also faces many problems.

### SUMMARY

According to a first aspect of embodiments of the present disclosure, a memory is provided, including: an active pillar row, including multiple active pillars extending in a first direction and arranged in a second direction, the multiple active pillars including a first active pillar located in a first region and a second active pillar located in a second region, where the second region is located on at least one side of the first region in the second direction, and the second direction is perpendicular to the first direction; a word line, extending in the first region and the second region in the second direction, and coupled to the multiple active pillars in the active pillar row; a data storage element, located on a first side of the first active pillar in the first direction, and coupled to the first active pillar; and a first contact plug, located in the second region, and coupled to the word line, where an orthographic projection of the first contact plug in the first direction overlaps with an orthographic projection of the second active pillar in the first direction.

In some embodiments, a size of the second active pillar in the first direction is less than a size of the first active pillar in the first direction.

In some embodiments, a size of the second active pillar in the second direction is equal to a size of the first active pillar in the second direction.

In some embodiments, a top surface of the second active pillar is substantially flush with a top surface of the first active pillar, or a bottom surface of the second active pillar is substantially flush with a bottom surface of the first active pillar.

In some embodiments, multiple first contact plugs are arranged in the second region in a staggered manner.

In some embodiments, the first semiconductor structure further includes a bit line, extending in the first region in a third direction, located on a second side that is of the first active pillar in the first direction and that is opposite to the first side, and coupled to the first active pillar, where the third direction is perpendicular to the first direction and intersects with the second direction.

In some embodiments, the first semiconductor structure further includes: a second contact plug, coupled to the bit line.

In some embodiments, the memory further includes: a second semiconductor structure, including a peripheral circuit, and bonded to the first semiconductor structure, where the word line is coupled to the peripheral circuit through the first contact plug.

In some embodiments, the second semiconductor structure is located on the second side of the first active pillar in the first direction.

According to a second aspect of embodiments of the present disclosure, a manufacturing method for a memory is provided, including steps as follows: A semiconductor substrate is provided. The semiconductor substrate has a first initial surface and a second initial surface that are opposite to each other. A first semiconductor structure is formed based on the semiconductor substrate. That a first semiconductor structure is formed based on the semiconductor substrate includes a step as follows: The semiconductor substrate is etched from the first initial surface to form an active pillar row. The active pillar row includes multiple active pillars extending in a first direction and arranged in a second direction. The multiple active pillars include a first active pillar located in a first region and a second active pillar located in a second region, where the second region is located on at least one side of the first region in the second direction, and the second direction is perpendicular to the first direction. A word line is formed in the semiconductor substrate. The word line extends in the first region and the second region in the second direction, and is coupled to the multiple active pillars in the active pillar row. A data storage element is formed on the semiconductor substrate. The data storage element is located on a first side of the first active pillar in the first direction, and is coupled to the first active pillar. The semiconductor substrate is thinned from the second initial surface until end portions that are of the multiple active pillars and that are away from the first initial surface are exposed. A first contact plug is formed in the second region. The first contact plug is coupled to the word line, where an orthographic projection of the first contact plug in the first direction overlaps with an orthographic projection of the second active pillar in the first direction.

In some embodiments, that the semiconductor substrate is etched from the first initial surface to form an active pillar row includes steps as follows: A trench isolation structure defining the multiple active pillars is formed in the semiconductor substrate; and a surface that is of the thinned semiconductor substrate and that is opposite to the first initial surface is adopted as a second surface; and that a first contact plug is formed in the second region includes steps as follows: A part of the second active pillar and a part of the trench isolation structure are etched from the second surface until the word line is exposed; a filling layer that covers the word line is formed; and the first contact plug is formed in the filling layer.

In some embodiments, a size of the remaining second active pillar in the first direction is less than a size of the first active pillar in the first direction.

In some embodiments, before the first contact plug is formed in the filling layer, that a first semiconductor structure is formed based on the semiconductor substrate further includes a step as follows: A bit line is formed in the first region. The bit line extends in a third direction, is located on a second side that is of the first active pillar in the first direction and that is opposite to the first side, and is coupled to the first active pillar, where the third direction is perpendicular to the first direction and intersects with the second direction.

In some embodiments, the manufacturing method further includes steps as follows: A second semiconductor structure is provided. The second semiconductor structure includes a peripheral circuit. The first semiconductor structure is bonded to the second semiconductor structure, so that the word line is coupled to the peripheral circuit through the first contact plug. The second semiconductor structure is disposed on the second side that is of the first active pillar in the first direction and that is opposite to the first side.

According to a third aspect of embodiments of the present disclosure, an electronic device is provided, including a processor and the memory provided in any embodiment of the present disclosure. The memory is coupled to the processor.

In the memory provided in the embodiments of the present disclosure, the second active pillar located in the second region can avoid or reduce stress impact on an end portion of the word line, thereby avoiding or alleviating a problem of bending of the end portion of the word line, and improving a yield.

### BRIEF DESCRIPTION OF DRAWINGS

FIG. 1A is a partial planar structural view of a memory;
FIG. 1B is a partial cross-sectional structural view taken along line A1-A2 in FIG. 1A;
FIG. 1C is a partial cross-sectional structural view taken along line B1-B2 in FIG. 1A;
FIG. 2A is a partial planar structural view of a first semiconductor structure of a memory according to some embodiments of the present disclosure;
FIG. 2B is a partial cross-sectional structural view taken along line A1-A2 in FIG. 2A;
FIG. 2C is another partial cross-sectional structural view taken along line A1-A2 in FIG. 2A;
FIG. 2D is a partial cross-sectional structural view taken along line B1-B2 in FIG. 2A;
FIG. 3A is a partial planar structural view of another first semiconductor structure of a memory according to some embodiments of the present disclosure;
FIG. 3B is a partial cross-sectional structural view taken along line A1-A2 in FIG. 3A;
FIG. 3C is another partial cross-sectional structural view taken along line A1-A2 in FIG. 3A;
FIG. 4A is a partial planar structural view of another first semiconductor structure of a memory according to some embodiments of the present disclosure;
FIG. 4B is a partial cross-sectional structural view taken along line A1-A2 in FIG. 4A;
FIG. 5A is a partial planar structural view of another first semiconductor structure of a memory according to some embodiments of the present disclosure;
FIG. 5B is a partial cross-sectional structural view taken along line A1-A2 in FIG. 5A;
FIG. 5C is a partial cross-sectional structural view taken along line B1-B2 in FIG. 5A;
FIG. 6A is a cross-sectional view of a memory according to some embodiments of the present disclosure;
FIG. 6B and FIG. 6C are partial cross-sectional structural views of a memory according to some embodiments of the present disclosure;
FIG. 7A is a cross-sectional view of another memory according to some embodiments of the present disclosure;
FIG. 7B and FIG. 7C are partial cross-sectional structural views of another memory according to some embodiments of the present disclosure;
FIG. 8 is a schematic flowchart of a manufacturing method for a memory according to some embodiments of the present disclosure;
FIG. 9 is a cross-sectional structural view of a semiconductor substrate according to some embodiments of the present disclosure;
FIG. 10A is a partial planar structural view of a structure obtained by performing step S210 according to some embodiments of the present disclosure;
FIG. 10B is a partial cross-sectional structural view taken along line A1-A2 in FIG. 10A;
FIG. 10C is a partial cross-sectional structural view taken along line B1-B2 in FIG. 10A;
FIG. 11A is a partial planar structural view of a structure obtained by performing step S220 according to some embodiments of the present disclosure;
FIG. 11B is a partial cross-sectional structural view taken along line A1-A2 in FIG. 11A;
FIG. 11C is a partial cross-sectional structural view taken along line B1-B2 in FIG. 11A;
FIG. 12A and FIG. 12B are partial cross-sectional structural views of a structure obtained by performing step S230 according to some embodiments of the present disclosure;
FIG. 12C and FIG. 12D are partial cross-sectional structural views of another structure obtained by performing step S230 according to some embodiments of the present disclosure;
FIG. 13A and FIG. 13B are partial cross-sectional structural views of a structure obtained by performing step S240 according to some embodiments of the present disclosure;
FIG. 13C and FIG. 13D are partial cross-sectional structural views of another structure obtained by performing step S240 according to some embodiments of the present disclosure;
FIG. 14A and FIG. 14B are partial cross-sectional structural views of a structure obtained by performing step S250 according to some embodiments of the present disclosure;
FIG. 14C and FIG. 14D are partial cross-sectional structural views of another structure obtained by performing step S250 according to some embodiments of the present disclosure; and
FIG. 15 is a schematic block diagram of a structure of an electronic device according to some embodiments of the present disclosure.

### DESCRIPTION OF EMBODIMENTS

The technical solutions of the present disclosure are further described below in detail with reference to the accompanying drawings and the embodiments. Although example implementation methods of the present disclosure are shown in the accompanying drawings, it should be understood that the present disclosure may be implemented in various forms without being limited by the implementations described herein. Instead, these implementations are provided to develop a more thorough understanding of the present disclosure and to fully convey the scope of the present disclosure to a person skilled in the art.

In the following paragraphs, the present disclosure is described more specifically by way of example with reference to the accompanying drawings. The advantages and features of the present disclosure will be clearer from the following description and claims. It should be noted that the accompanying drawings are presented in a highly simplified form and are not to exact scale, and are merely intended to conveniently and clearly assist in describing the embodiments of the present disclosure.

It may be understood that meanings of "on", "over", and "above" in the present disclosure should be understood in the broadest sense, so that "on" means that it is "on" something with no intermediate feature or layer (that is, directly on something), and further includes the meaning that it is "on" something with an intermediate feature or layer.

In the embodiments of the present disclosure, the terms "first", "second", "third", and the like are intended to distinguish between similar objects but do not necessarily describe a specific order or sequence.

In the embodiments of the present disclosure, the term "layer" refers to a material part including a region having a thickness. The layer may extend over the whole of a lower or upper structure, or may have a range smaller than the range of the lower or upper structure. In addition, the layer may be a region of a homogeneous or heterogeneous continuous structure whose thickness is thinner than the thickness of a continuous structure. For example, the layer may be located between the top surface and the bottom surface of the continuous structure, or the layer may be located between any horizontal surface pair at the top surface and the bottom surface of the continuous structure. The layer may extend horizontally, vertically, and/or along an inclined surface. The layer may include multiple sublayers.

In the embodiments of the present disclosure, the term "coupling" refers to two (or more) conductive structures being operatively connected to each other, and according to an actual need, may include but is not limited to the following cases: (1) The two conductive structures are directly electrically connected; (2) the two conductive structures are indirectly electrically connected (through another conductive structure); (3) although the two conductive structures are not electrically connected (for example, an insulating layer is disposed therebetween), but one of the two conductive structures may control electrical performance of the other conductive structure in response to an electrical signal, for example, a gate (or a word line) is coupled to an active region (or a channel region).

It should be noted that the technical solutions and the technical features described in the embodiments of the present disclosure may be randomly combined when there is no conflict.

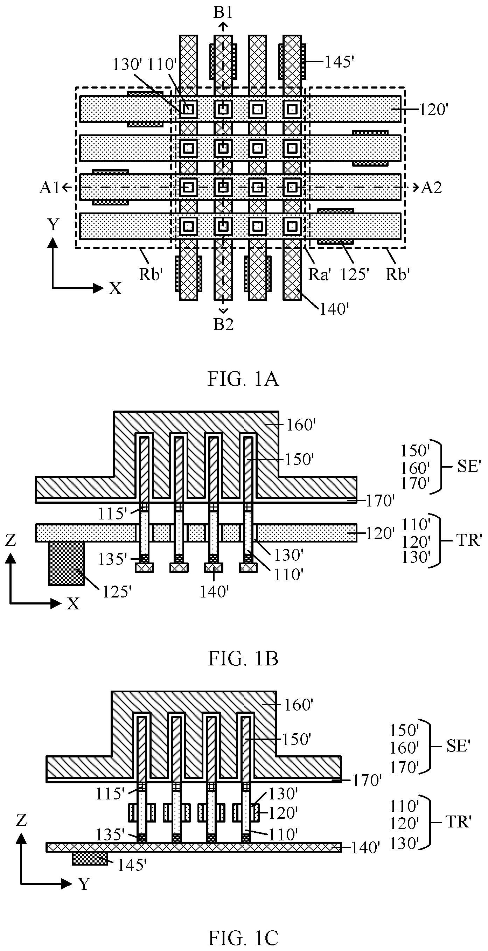

FIG. 1A is a partial planar structural view of a memory. FIG. 1B is a partial cross-sectional structural view taken along line A1-A2 in FIG. 1A. FIG. 1C is a partial cross-sectional structural view taken along line B1-B2 in FIG. 1A. As shown in FIG. 1A to FIG. 1C, the memory includes multiple arrayed transistors TR', and multiple word lines 120' and multiple bit lines 140' that are separately correspondingly coupled to the multiple transistors TR'.

As shown in FIG. 1A to FIG. 1C, each of the transistors TR' includes an active pillar 110' extending in the vertical direction Z, a gate 120' surrounding the active pillar 110' (a part that is of the word line 120' and that surrounds the active pillar 110' serves as the gate 120'), and a gate dielectric layer 130' disposed between the active pillar 110' and the gate 120'. As shown in FIG. 1A and FIG. 1B, each of the word lines 120' extends in the horizontal direction X and surrounds a row of active pillars 110', so that the row of transistors TR' are all formed into gate-all-around (Gate-All-Around, GAA) transistors. As shown in FIG. 1A and FIG. 1C, each of the bit lines 140' extends in the horizontal direction Y, and is coupled to a column of active pillars 110' (that is, a column of transistors). For example, the bit line 140 may be coupled to a corresponding active pillar 110' through a bit line contact plug 135'.

As shown in FIG. 1B and FIG. 1C, the memory further includes multiple capacitors SE' correspondingly coupled to the multiple transistors TR', and each of the capacitors SE' includes a first electrode 150', a second electrode 160', and a capacitor dielectric layer 170' disposed between the first electrode 150' and the second electrode 160'. For example, the first electrode 150' may be coupled to a corresponding active pillar 110' through a contact pad 115'. For example, second electrodes 160' of the multiple capacitors SE' may be formed into a common electrode 160'.

As shown in FIG. 1A to FIG. 1C, the multiple transistors TR' are disposed in an array region Ra'. The word line 120' extends from the array region Ra' to a peripheral region Rb' outside the array region Ra', that is, an end portion of the word line 120' is located in the peripheral region Rb'; and a first contact plug 125' coupled to the end portion of the word line 120' is disposed in the peripheral region Rb'. Similarly, the bit line 140' extends from the array region Ra' to a peripheral region outside the array region Ra', and is coupled to a second contact plug 145' disposed in the peripheral region. For example, the word line 120' may be coupled to a word line driver (for example, a sub-word line driver, Sub-Word line Driver, SWD) in a peripheral circuit (not shown in the figure) through the first contact plug 125', and the bit line 140' may be coupled to a sense amplifier (Sense Amplifier, SA) in a peripheral circuit (not shown in the figure) through the second contact plug 145'.

It should be noted that, for clarity and brevity, some insulating layers, dielectric layers, and/or the like are omitted in FIG. 1A to FIG. 1C.

During research, inventors of this application note that, in the memory shown in FIG. 1A to FIG. 1C, the end portion of the word line 120' is disposed in a dielectric layer (not shown in the figure) of the peripheral region Rb'. Affected by stress, a bending (bending) problem easily occurs at the end portion of the word line 120', resulting in an alignment problem between the first contact plug 125' and the word line 120' when the first contact plug 125' coupled to the end portion of the word line 120' is subsequently formed, which may cause a short circuit (for example, one first contact plug 125' is simultaneously coupled to two word lines 120').

At least some embodiments of the present disclosure provide a memory. The memory includes a first semiconductor structure. The first semiconductor structure includes an active pillar row, a word line, a data storage element, and a first contact plug. The active pillar row includes multiple active pillars extending in a first direction and arranged in a second direction. The multiple active pillars include a first active pillar located in a first region and a second active pillar located in a second region. The second region is located on at least one side of the first region in the second direction, and the second direction is perpendicular to the first direction. The word line extends in the first region and the second region in the second direction, and is coupled to the multiple active pillars in the active pillar row. The data storage element is located on a first side of the first active pillar in the first direction, and is coupled to the first active pillar. The first contact plug is located in the second region, and is coupled to the word line. An orthographic projection of the first contact plug in the first direction overlaps with an orthographic projection of the second active pillar in the first direction.

In the memory provided in the embodiments of the present disclosure, the second active pillar located in the second region can avoid or reduce stress impact on an end portion of the word line, thereby avoiding or alleviating a problem of bending of the end portion of the word line, and improving a yield.

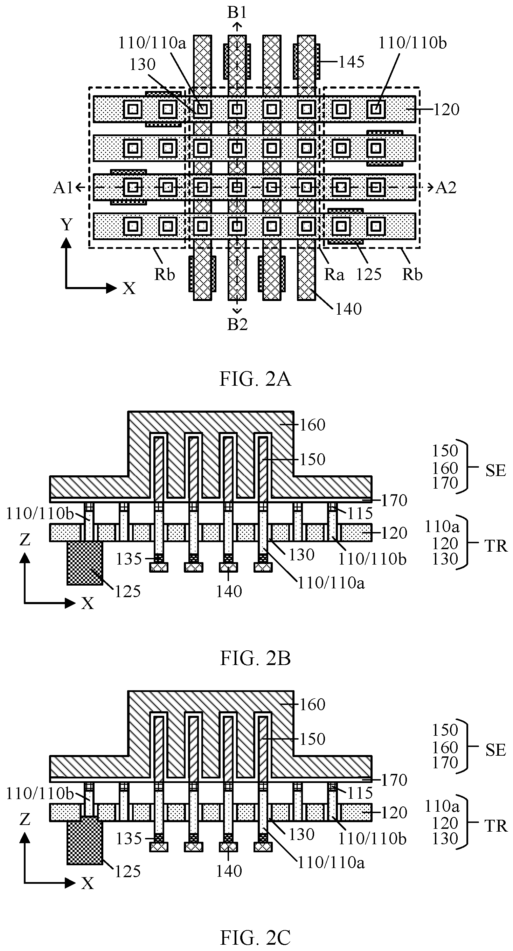

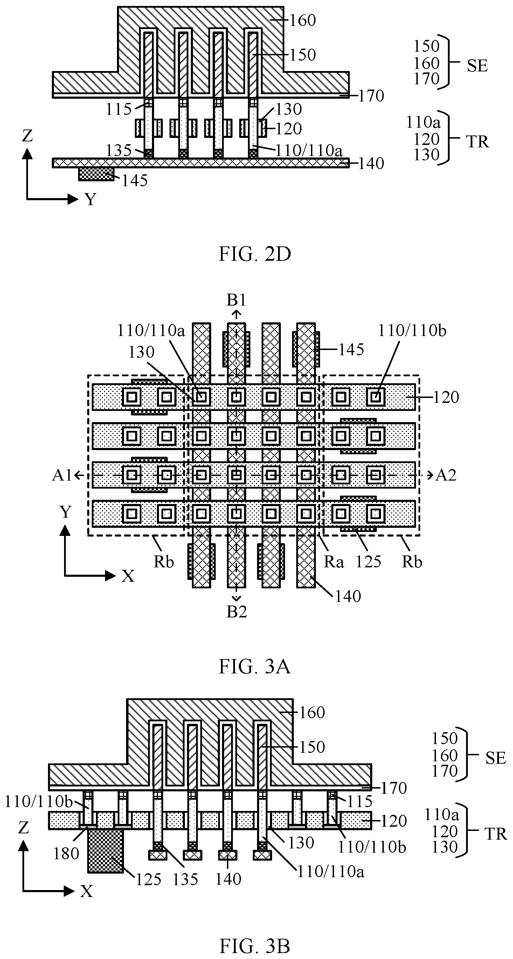

The memory provided in the embodiments of the present disclosure includes a first semiconductor structure. FIG. 2A is a partial planar structural view of a first semiconductor structure of a memory according to some embodiments of the present disclosure. FIG. 2B is a partial cross-sectional structural view taken along line A1-A2 in FIG. 2A. FIG. 2C is another partial cross-sectional structural view taken along line A1-A2 in FIG. 2A. FIG. 2D is a partial cross-sectional structural view taken along line B1-B2 in FIG. 2A.

For example, as shown in FIG. 2A to FIG. 2D, the first semiconductor structure includes an active pillar row. The active pillar row includes multiple active pillars 110 extending in a first direction Z (that is, the vertical direction Z) and arranged in a second direction X (that is, the horizontal direction X). The multiple active pillars 110 include a first active pillar 110a located in a first region Ra (that is, an array region Ra) and a second active pillar 110b located in a second region Rb (that is, a peripheral region Rb). The second region Rb is located on at least one side of the first region Ra in the second direction X. For example, the second direction X is perpendicular to the first direction Z. For example, as shown in FIG. 2A, the first semiconductor structure may include two second regions Rb, and the two second regions Rb are located on two opposite sides of the first region Ra in the second direction X. It may be understood that a quantity of active pillar rows, a quantity of first active pillars 110a, and a quantity of second active pillars 110b in the figures are illustrative, and should not be construed as limitations on this embodiment of the present disclosure. For example, the first semiconductor structure may include one or more active pillar rows. Each of the active pillar rows may include one or more first active pillars 110a and one or more second active pillars 110b. In this embodiment of the present disclosure, the active pillar row may also be referred to as a semiconductor pillar row, the active pillar 110 may also be referred to as a semiconductor pillar 110, the first active pillar 110a may also be referred to as a first semiconductor pillar 110a, and the second active pillar 110b may also be referred to as a second semiconductor pillar 110b.

For example, the material of the active pillar 110 may include any suitable semiconductor material, for example, silicon, germanium, or gallium arsenide.

For example, as shown in FIG. 2B and FIG. 2C, the size of the second active pillar 110b in the first direction Z is less than the size of the first active pillar 110a in the first direction Z.

For example, as shown in FIG. 2B and FIG. 2C, the size of the second active pillar 110b in the second direction X is equal to the size of the first active pillar 110a in the second direction X. It should be noted that, due to a machining error, in this embodiment of the present disclosure, "sizes are equal" includes a case in which sizes are strictly equal, and also includes a case in which sizes are approximately equal, where "sizes are approximately equal" means that a relative difference between the sizes is less than or equal to 5%.

For example, as shown in FIG. 2A to FIG. 2D, the first semiconductor structure further includes a word line 120. The word line 120 extends in the first region Ra and the second region Rb in the second direction X, and is coupled to the multiple active pillars 110 in the active pillar row. For example, the first semiconductor structure may further include a gate dielectric layer 130 disposed between each of the active pillars 110 and the word line 120. A part that is of the word line 120 and that covers the gate dielectric layer 130 may serve as a gate 120. The gate 120, the first active pillar 110a, and the gate dielectric layer 130 located therebetween form a transistor TR (vertical transistor). It may be understood that a structure of the vertical transistor TR in the figures is illustrative, and should not be construed as a limitation on this embodiment of the present disclosure. For example, the vertical transistor TR may be a gate-all-around (GAA) transistor (as shown in the figure), or may be a one-side gate transistor, a two-side (for example, opposite-side) gate transistor, a three-side gate transistor, or the like.

For example, the material of the word line 120 may include any suitable conductive material, for example, titanium nitride (TiN), tantalum nitride (TaN), tungsten, metal silicide, or any combination thereof. For example, the material of the gate dielectric layer 130 may include any suitable dielectric material, for example, silicon oxide, silicon nitride, a high-K dielectric material, or any combination thereof. For example, the high-K dielectric material may include but is not limited to hafnium oxide (HfO₂) or zirconium oxide (ZrO₂).

As shown in FIG. 2B to FIG. 2D, the first semiconductor structure further includes a data storage element SE. The data storage element SE is located on a first side of the first active pillar 110a in the first direction Z, and is coupled to the first active pillar 110a. An example in which the data storage element SE is a capacitor is adopted to describe this embodiment of the present disclosure, and should not be construed as a limitation on the present disclosure. It may be understood that the data storage element SE may not be limited to a DRAM storage element (that is, a capacitor). For example, the data storage element SE may be a FeRAM (ferroelectric random access memory) storage element, a PCM (phase change memory) storage element, or a MRAM (magnetic random access memory) storage element. That is, the memory provided in this embodiment of the present disclosure may be a DRAM, a FeRAM, a PCM, a MRAM, or the like.

For example, as shown in FIG. 2B to FIG. 2D, if the data storage element SE is a capacitor, the capacitor SE may include a first electrode 150, a second electrode 160, and a capacitor dielectric layer 170 disposed between the first electrode 150 and the second electrode 160. For example, the first electrode 150 may be coupled to a corresponding first active pillar 110a through a contact pad 115. For example, second electrodes 160 of multiple capacitors SE may be formed into a common electrode 160.

For example, the material of each of the first electrode 150 and the second electrode 160 includes any suitable conductive material, for example, titanium nitride (TiN), tantalum nitride (TaN), tungsten, metal silicide, doped polysilicon, or any combination thereof. For example, the material of the capacitor dielectric layer 170 includes any suitable dielectric material, for example, silicon oxide, silicon nitride, a high-K dielectric material, or any combination thereof. For example, the material of the capacitor dielectric layer 170 may also include a ferroelectric or antiferroelectric dielectric material, for example, hafnium oxide of a ferroelectric phase or hafnium zirconium oxide of a ferroelectric phase. In other words, the capacitor SE may be a ferroelectric capacitor.

It should be noted that the structure of the capacitor SE in the accompanying drawings of the present disclosure is illustrative. The structure of the capacitor SE is not limited in this embodiment of the present disclosure, provided that the first electrode 150, the second electrode 160, and the capacitor dielectric layer 170 can be disposed to form the capacitor. For example, the first electrode 150 may be in a columnar shape (as shown in the figure), may be in a plate shape, may be in a U shape, or may be in any suitable shape. The second electrode 160 conformally covers a sidewall and/or a top surface of the first electrode 150, and the capacitor dielectric layer 170 is located between the first electrode 150 and the second electrode 160. For example, in some embodiments, one or more support layers for supporting the first electrode may be disposed in the first semiconductor structure, each of the support layers is grid-shaped, and the capacitor dielectric layer 170 and the second electrode 160 may cover a part of the support layer.

For example, the material of the contact pad 115 may include any suitable conductive material, for example, titanium nitride (TiN), tantalum nitride (TaN), tungsten, metal silicide, doped polysilicon, or any combination thereof. For example, the shape and the structure of the contact pad 115 may be disposed as required to coordinate with an arrangement manner of the multiple capacitors SE (for example, quadrilateral arrangement or hexagonal close-packed arrangement). It should be noted that, in some examples, the contact pad 115 may be omitted, that is, the first electrode 150 may be directly coupled to the transistor TR.

For example, as shown in FIG. 2A to FIG. 2C, the first semiconductor structure further includes a first contact plug 125, and the first contact plug 125 is disposed in the second region Rb and is coupled to the word line 120. An orthographic projection of the first contact plug 125 in the first direction Z overlaps with an orthographic projection of the second active pillar 110b in the first direction Z. In this embodiment of the present disclosure, the orthographic projection in the first direction Z refers to an orthographic projection in a virtual plane perpendicular to the first direction Z; and the orthographic projection of the first contact plug 125 in the first direction Z may at least partially overlap with an orthographic projection of at least one second active pillar 110b in the first direction Z.

For example, in some embodiments, as shown in FIG. 2B and FIG. 2C, the first contact plug 125 may contact at least one second active pillar 110b. For example, in some embodiments, as shown in FIG. 2B, the first contact plug 125 may contact only a surface (that is, a bottom surface shown in FIG. 2B) that is of the word line 120 and that is perpendicular to the first direction Z. For example, in some other embodiments, as shown in FIG. 2C, the first contact plug 125 may contact a surface (a bottom surface shown in FIG. 2C) that is of the word line 120 and that is perpendicular to the first direction Z, and may further contact a part of a side surface of the word line 120, to increase a contact area therebetween and reduce contact resistivity therebetween.

For example, as shown in FIG. 2A, a first end portion of an odd-numbered word line 120 (for example, an end portion located in the second region Rb on a left side of the first region Ra in FIG. 2A) is coupled to a corresponding first contact plug 125, and a second end portion of an even-numbered word line 120 (for example, an end portion located in the second region Rb on a right side of the first region Ra in FIG. 2A) is coupled to a corresponding first contact plug 125. For example, as shown in FIG. 2A, multiple first contact plugs 120 are arranged in a third direction Y (the horizontal direction Y) in a staggered manner in the second region Rb (the second region Rb on the left side or the second region Rb on the right side). For example, the third direction Y is perpendicular to the first direction Z, and intersects with the second direction X. For example, the third direction Y is perpendicular to the second direction X.

For example, the material of the first contact plug 125 may include any suitable conductive material, for example, titanium nitride (TiN), tantalum nitride (TaN), tungsten, metal silicide, or any combination thereof.

For example, in some embodiments, as shown in FIG. 2B and FIG. 2C, a top surface of the second active pillar 110b (that is, a surface that is of the second active pillar 110b and that is away from the first contact plug 125) may be substantially flush with a top surface of the first active pillar 110a (that is, a surface that is of the first active pillar 110a and that is close to the first electrode 150).

For example, as shown in FIG. 2B and FIG. 2C, the top surface of the second active pillar 110b may also be provided with the contact pad 115 coupled thereto, and the contact pad 115 and the first contact plug 125 are located on two opposite sides of the second active pillar 110b in the first direction Z.

For example, as shown in FIG. 2A to FIG. 2D, the first semiconductor structure may further include a bit line 140. The bit line 140 extends in the first region Ra in the third direction Y. The bit line 140 is located on a second side that is of the first active pillar 110a in the first direction Z and that is opposite to the first side, and is coupled to the first active pillar 110a. For example, the bit line 140 may be coupled to a column of first active pillars 110a (including multiple first active pillars arranged in the third direction Y). For example, the bit line 140 may be coupled to the transistor TR through a bit line contact plug 135.

For example, the material of the bit line 140 may include any suitable conductive material, for example, titanium nitride (TiN), tantalum nitride (TaN), tungsten, metal silicide, doped polysilicon, or any combination thereof. For example, the material of the bit line contact plug 135 may include any suitable conductive material, for example, titanium nitride (TiN), tantalum nitride (TaN), tungsten, metal silicide, doped polysilicon, or any combination thereof. It should be noted that, in some examples, the bit line contact plug 135 may be omitted, that is, the bit line 140 may be directly coupled to the transistor TR.

For example, as shown in FIG. 2A to FIG. 2D, the first semiconductor structure may further include a second contact plug 145, and the second contact plug 145 is coupled to the bit line 140.

For example, as shown in FIG. 2A, a first end portion of an odd-numbered bit line 140 (for example, an end portion located on a lower side of the first region Ra in FIG. 2A) is coupled to a corresponding second contact plug 145, and a second end portion of an even-numbered bit line 140 (for example, an end portion located on an upper side of the first region Ra in FIG. 2A) is coupled to a corresponding second contact plug 145.

For example, the material of the second contact plug 145 may include any suitable conductive material, for example, titanium nitride (TiN), tantalum nitride (TaN), tungsten, metal silicide, or any combination thereof.

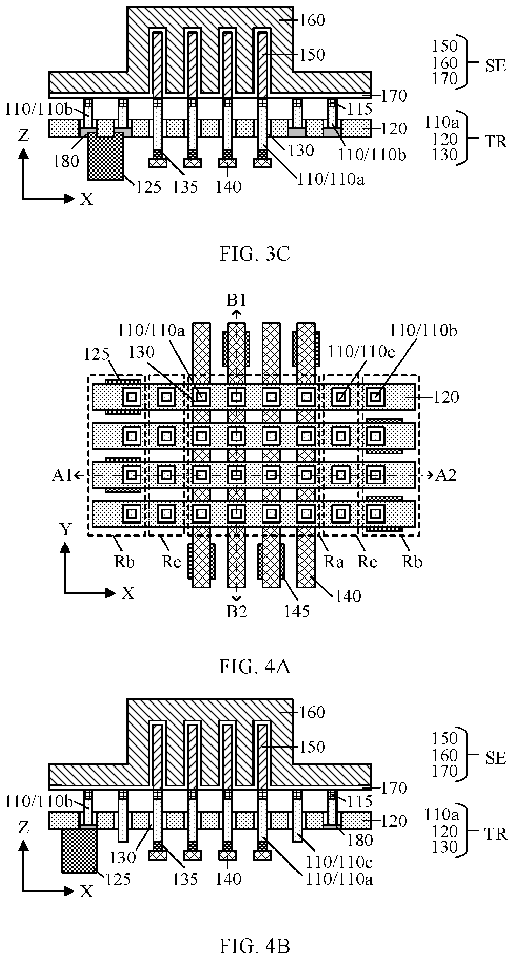

FIG. 3A is a partial planar structural view of another first semiconductor structure of a memory according to some embodiments of the present disclosure. FIG. 3B is a partial cross-sectional structural view taken along line A1-A2 in FIG. 3A. FIG. 3C is another partial cross-sectional structural view taken along line A1-A2 in FIG. 3A. It may be understood that the partial cross-sectional structural view taken along line B1-B2 in FIG. 3A is similar to FIG. 2D. For brevity, the partial cross-sectional structural view taken along line B1-B2 in FIG. 3A is omitted in the present disclosure.

A main difference between the first semiconductor structure shown in FIG. 3A to FIG. 3C and the first semiconductor structure shown in FIG. 2A to FIG. 2C lies in that the first semiconductor structure shown in FIG. 3A to FIG. 3C further includes an isolation portion 180 (as shown in FIG. 3B and FIG. 3C). The isolation portion 180 is disposed on a bottom surface of the second active pillar 110b (that is, a surface that is of the second active pillar 110b and that is away from the contact pad 115). The isolation portion 180 located between the first contact plug 125 and the second active pillar 110b is configured to insulate the first contact plug 125 from the second active pillar 110b. That is, in some embodiments, although the orthographic projection of the first contact plug 125 in the first direction Z overlaps with the orthographic projection of the second active pillar 110b in the first direction Z, the first contact plug 125 may not contact the second active pillar 110b. Correspondingly, as shown in FIG. 3B, the size of the gate dielectric layer 130 (also referred to as a second gate dielectric layer) on a sidewall of the second active pillar (110b) in the first direction Z is less than the size of the gate dielectric layer 130 (also referred to as a first gate dielectric layer) on a sidewall of the first active pillar 110a in the first direction Z.

For example, the material of the isolation portion 180 may include any suitable insulating material, for example, silicon oxide or silicon nitride.

A difference between the first semiconductor structure shown in FIG. 3A to FIG. 3C and the first semiconductor structure shown in FIG. 2A to FIG. 2C further lies in that, in the first semiconductor structure shown in FIG. 3A to FIG. 3C, multiple first contact plugs 125 located in the same second region are sequentially arranged in the third direction Y.

In addition, a difference between the first semiconductor structure shown in FIG. 3A to FIG. 3C and the first semiconductor structure shown in FIG. 2A to FIG. 2C further lies in that, in the first semiconductor structure shown in FIG. 2A to FIG. 2C, an orthographic projection of one first contact plug 125 in the first direction Z overlaps with an orthographic projection of one second active pillar 110b in the first direction Z, but in the first semiconductor structure shown in FIG. 3A to FIG. 3C, an orthographic projection of one first contact plug 125 in the first direction Z overlaps with orthographic projections of multiple (two) second active pillars 110b in the first direction Z.

It may be understood that the foregoing differences are mutually independent, that is, any one or more of the foregoing differences may be combined with the embodiment shown in FIG. 2A to FIG. 2C to obtain a new embodiment.

FIG. 4A is a partial planar structural view of another first semiconductor structure of a memory according to some embodiments of the present disclosure. FIG. 4B is a partial cross-sectional structural view taken along line A1-A2 in FIG. 4A. It may be understood that the partial cross-sectional structural view taken along line B1-B2 in FIG. 4A is similar to FIG. 2D. For brevity, the partial cross-sectional structural view taken along line B1-B2 in FIG. 4A is omitted in the present disclosure.

A main difference between the first semiconductor structure shown in FIG. 4A and FIG. 4B and the first semiconductor structure shown in FIG. 3A and FIG. 3B lies in that, in the first semiconductor structure shown in FIG. 4A and FIG. 4B, the multiple active pillars 110 of the active pillar row further include a third active pillar 110c located in a third region Rc, and the third region Rc is located between the first region Ra and the second region Rb. For example, as shown in FIG. 4B, the size of the third active pillar 110c in the first direction Z is greater than the size of the second active pillar 110b in the first direction Z. For example, as shown in FIG. 4B, the size of the third active pillar 110c in the first direction Z is substantially equal to the size of the first active pillar 110a in the first direction Z.

For example, in some embodiments, as shown in FIG. 4B, top surfaces of the first active pillar 110a, the second active pillar 110b, and the third active pillar 110c are substantially flush with each other; and bottom surfaces of the first active pillar 110a and the third active pillar 110c are substantially flush with each other.

For example, as shown in FIG. 4B, the top surface of the third active pillar 110c may be provided with a contact pad 115 coupled thereto. For example, as shown in FIG. 4B, the first semiconductor structure may not be provided with a bit line 140 coupled to the third active pillar 110c, and correspondingly, the bottom surface of the third active pillar 110c may not be provided with a bit line contact plug 135 coupled thereto.

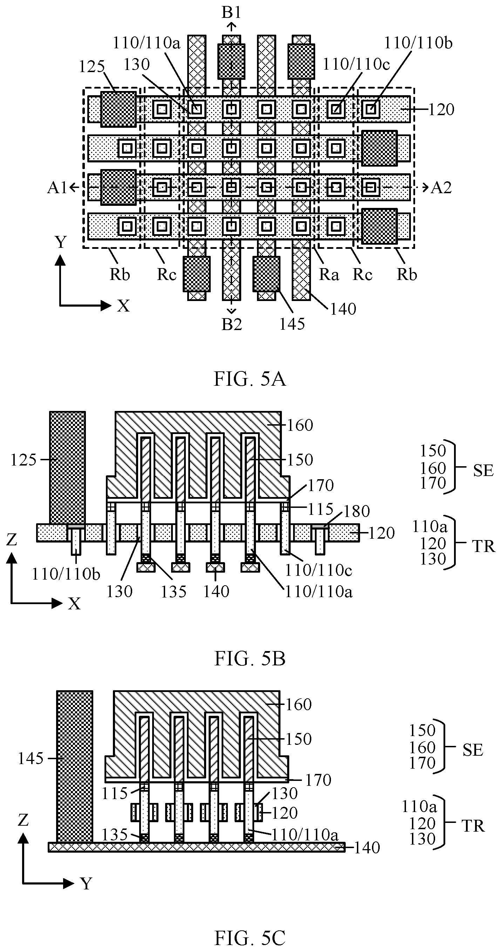

FIG. 5A is a partial planar structural view of another first semiconductor structure of a memory according to some embodiments of the present disclosure. FIG. 5B is a partial cross-sectional structural view taken along line A1-A2 in FIG. 5A. FIG. 5C is a partial cross-sectional structural view taken along line B1-B2 in FIG. 5A.

A main difference between the first semiconductor structure shown in FIG. 5A to FIG. 5C and the first semiconductor structure shown in FIG. 4A and FIG. 4B lies in that, in the first semiconductor structure shown in FIG. 4A and FIG. 4B, the first contact plug 125 is located on a side that is of the word line 120 in the first direction Z and that is away from the data storage element SE, and the second contact plug 145 is located on a side that is of the bit line 140 in the first direction Z and that is away from the data storage element SE, but in the first semiconductor structure shown in FIG. 5A to FIG. 5C, the first contact plug 125 is located on a side that is of the word line 120 in the first direction Z and that is close to the data storage element SE, and the second contact plug 145 is located on a side that is of the bit line 140 in the first direction Z and that is close to the data storage element SE. Correspondingly, as shown in FIG. 5B, the isolation portion 180 may be disposed on the top surface of the second active pillar 110b. The isolation portion 180 located between the first contact plug 125 and the second active pillar 110b is configured to insulate the first contact plug 125 from the second active pillar 110b.

For example, in some embodiments, as shown in FIG. 5B, a bottom surface of the second active pillar 110b (that is, a surface that is of the second active pillar 110b and that is away from the first contact plug 125) may be substantially flush with a bottom surface of the first active pillar 110a (that is, a surface that is of the first active pillar 110a and that is away from the first electrode 150).

For example, in some embodiments, as shown in FIG. 5B, bottom surfaces of the first active pillar 110a, the second active pillar 110b, and the third active pillar 110c are substantially flush with each other; and top surfaces of the first active pillar 110a and the third active pillar 110c are substantially flush with each other.

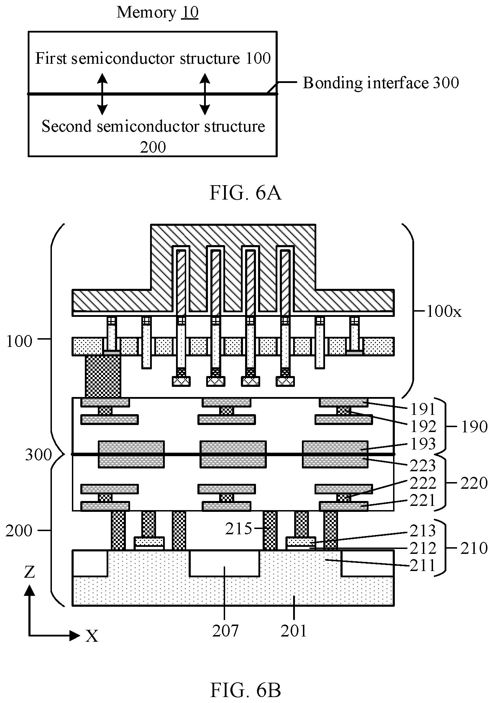

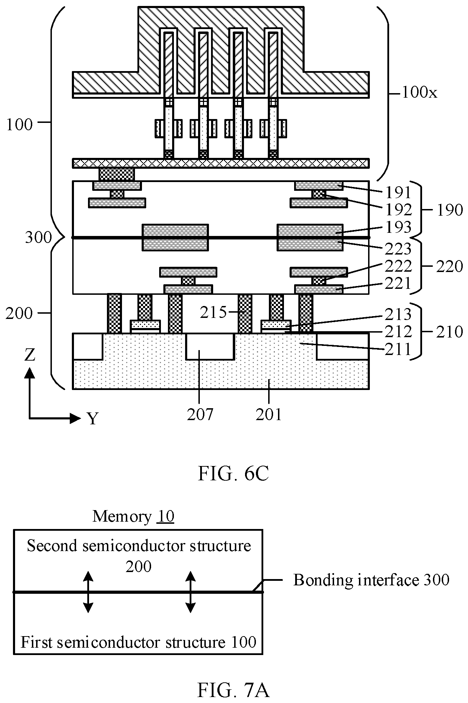

FIG. 6A is a cross-sectional view of a memory according to some embodiments of the present disclosure. FIG. 6B and FIG. 6C are partial cross-sectional structural views of a memory according to some embodiments of the present disclosure. For example, as shown in FIG. 6A to FIG. 6C, the memory 10 may include not only the first semiconductor structure 100, but also a second semiconductor structure 200. The second semiconductor structure 200 may include a peripheral circuit (the peripheral circuit is shown as multiple transistors 210), and the second semiconductor structure 200 may be bonded to the first semiconductor structure 100 through a bonding interface 300, so that the peripheral circuit in the second semiconductor structure 200 is correspondingly coupled to a word line and a bit line (refer to the word line 120 and the bit line 140 in the foregoing embodiment) in the first semiconductor structure 100.

For example, as shown in FIG. 6B and FIG. 6C, in addition to the structure described in the foregoing embodiment (shown as a structure 100x in the figure), the first semiconductor structure 100 may further include a first interconnection layer 190, and the first interconnection layer 190 is disposed on a side that is of the transistor TR and that is away from the data storage element SE. The second semiconductor structure 200 may further include a second interconnection layer 220, and the second interconnection layer 220 is disposed on the peripheral circuit. The memory 10 may further include a bonding interface 300 disposed between the first interconnection layer 190 and the second interconnection layer 220. For example, the first interconnection layer 190 and the second interconnection layer 220 are bonded through the bonding interface 300, to implement bonding between the first semiconductor structure 100 and the second semiconductor structure 200. Herein, the first semiconductor structure 100 and the second semiconductor structure 200 are bonded in a form of "Back to Face" (Back to Face) (that is, a back surface of the first semiconductor structure is opposite to a front surface of the second semiconductor structure). For example, the foregoing bonding may be implemented through a hybrid bonding (hybrid bonding) technology. In addition, it may be understood that, although the structure 100x in FIG. 6B and FIG. 6C takes the structures shown in FIG. 4B and FIG. 2D as examples, the structure 100x is not limited thereto. For example, the structure 100x in FIG. 6B may be replaced with any structure shown in FIG. 2B, FIG. 2C, FIG. 3B, and FIG. 3C. Correspondingly, for details of the structure 100x in FIG. 6B and FIG. 6C, refer to foregoing related descriptions. Details are not described herein again.

For example, in some embodiments, as shown in FIG. 6B and FIG. 6C, the first interconnection layer 190 may include multiple layers of first interconnection lines 191, a first interconnection via (Via) 192 disposed between adjacent layers of first interconnection lines 191, and multiple first bonding pads 193. Similarly, the second interconnection layer 220 may include multiple layers of second interconnection lines 221, a second interconnection via (Via) 222 disposed between adjacent layers of second interconnection lines 221, and multiple second bonding pads 223. The multiple first bonding pads 193 and the multiple second bonding pads 223 are bonded to each other through the bonding interface 300. For example, each of the first contact plug 125 and the second contact plug 145 is coupled to the peripheral circuit through the first interconnection lines 191, the first interconnection via 192, the first bonding pads 193, the second bonding pads 223, the second interconnection via 222, and the second interconnection lines 221.

For example, in some embodiments, as shown in FIG. 6B and FIG. 6C, the second semiconductor structure 200 may include a semiconductor substrate 201, and the peripheral circuit may include multiple transistors 210, where at least some of the multiple transistors 210 are disposed in the semiconductor substrate 201 and are configured to implement structures and functions of control circuits such as a word line driver (for example, a sub-word line driver, Sub-Word line Driver) and a sense amplifier (Sense Amplifier, SA). For example, as shown in FIG. 6B and FIG. 6C, each of the transistors 210 may include an active region 211 in the substrate, a gate 213 disposed in the active region 211, and a gate dielectric layer 212 located between the active region 211 and the gate 213. A trench isolation structure 207 defining active regions 211 may be disposed in the semiconductor substrate 201. For example, as shown in FIG. 6B and FIG. 6C, the transistor 210 may be coupled to a corresponding second interconnection line 221 through a contact plug 215. For example, the material of the semiconductor substrate 201 may include any suitable semiconductor material, for example, silicon, germanium, gallium arsenide, or an oxide semiconductor material. For example, the material of the gate 213 may include any suitable conductive material, for example, titanium nitride (TiN), tantalum nitride (TaN), tungsten, metal silicide, doped polysilicon, or any combination thereof. For example, the material of the gate dielectric layer 212 may include any suitable dielectric material, for example, silicon oxide, silicon nitride, a high-K dielectric material, or any combination thereof. It should be noted that the transistor 210 in the accompanying drawings is illustrative, and the structure of the transistor 210 is not limited in this embodiment of the present disclosure. For example, the transistor 210 may be a planar transistor (as shown in the figure), or may be a fin field-effect transistor (FinFET).

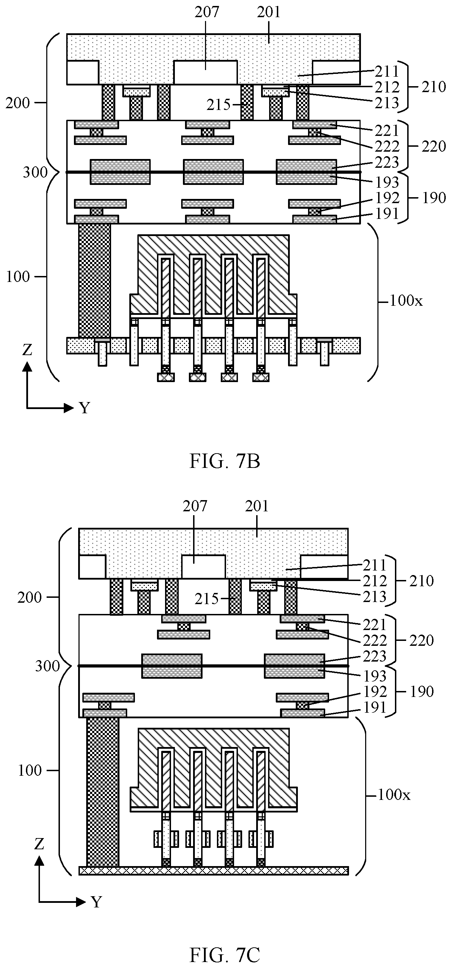

FIG. 7A is a cross-sectional view of another memory according to some embodiments of the present disclosure. FIG. 7B and FIG. 7C are partial cross-sectional structural views of another memory according to some embodiments of the present disclosure.

A main difference between the memory shown in FIG. 7A and the memory shown in FIG. 6A lies in that, in the memory 10 shown in FIG. 6A, the first semiconductor structure 100 is located above the second semiconductor structure 200, but in the memory 10 shown in FIG. 7A, the second semiconductor structure 200 is located above the first semiconductor structure 100. For example, as shown in FIG. 7B and FIG. 7C, to implement the architecture of the memory 10 shown in FIG. 7A, the structure 100x in the first semiconductor structure 100 may adopt the structure shown in FIG. 5B and FIG. 5C.

For example, as shown in FIG. 7A to FIG. 7C, the first interconnection layer 190 may be disposed on a side that is of the data storage element SE and that is away from the transistor TR. In addition, the first semiconductor structure 100 and the second semiconductor structure 200 are bonded in a form of Face to Face (Face to Face) (that is, a front surface of the first semiconductor structure is opposite to a front surface of the second semiconductor structure).

For remaining details of the memory in the embodiment shown in FIG. 7B and FIG. 7C, refer to the foregoing related descriptions of FIG. 6B and FIG. 6C. Details are not described herein again.

It should be noted that, for clarity and brevity, some insulating layers, dielectric layers, and/or the like in the memory are omitted in the accompanying drawings of the present disclosure.

In the memory provided in the embodiments of the present disclosure, the second active pillar located in the second region can avoid or reduce stress impact on an end portion of the word line, thereby avoiding or alleviating a problem of bending of the end portion of the word line, and improving a yield.

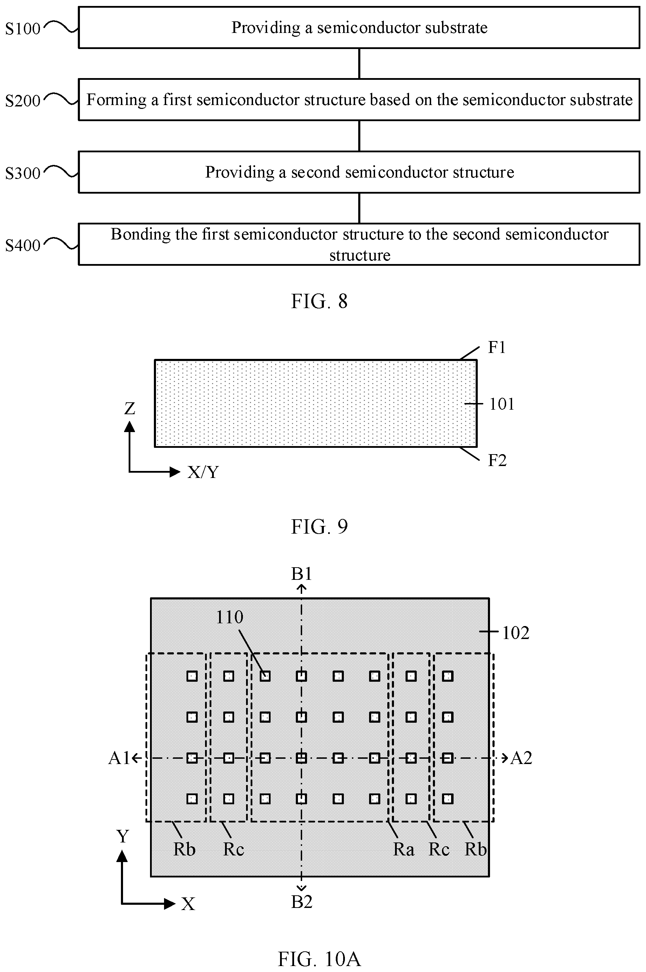

At least some embodiments of the present disclosure further provide a manufacturing method for a memory, and the manufacturing method may be adopted to manufacture the memory in the foregoing embodiments. FIG. 8 is a schematic flowchart of a manufacturing method for a memory according to some embodiments of the present disclosure. For example, as shown in FIG. 8, the manufacturing method may include the following steps S100 to S400.

In the step of S100, a semiconductor substrate is provided.

FIG. 9 is a cross-sectional structural view of a semiconductor substrate according to some embodiments of the present disclosure. For example, as shown in FIG. 9, the semiconductor substrate 101 has a first initial surface F1 and a second initial surface F2 that are opposite to each other. For example, the material of the semiconductor substrate 101 may include any suitable semiconductor material, for example, silicon, germanium, or gallium arsenide.

In the step of S200, a first semiconductor structure is formed based on the semiconductor substrate.

For example, in some embodiments, step S200 may include the following steps S210 to S270.

In the step of S210, the semiconductor substrate is etched from the first initial surface to form an active pillar row.

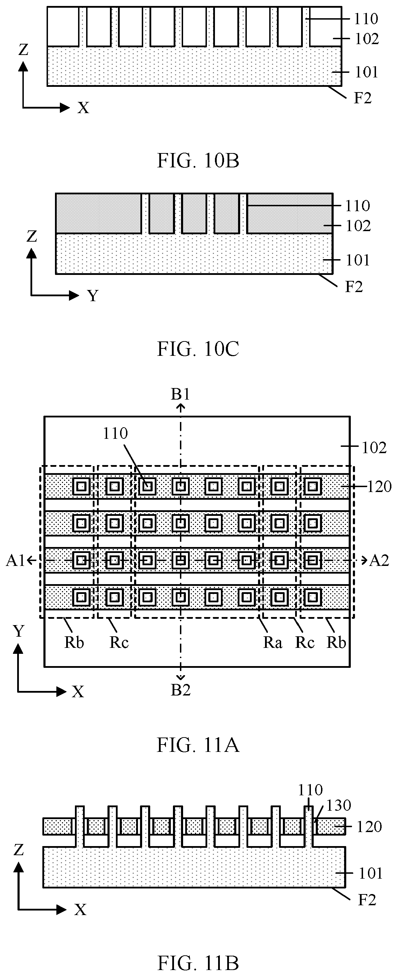

FIG. 10A is a partial planar structural view of a structure obtained by performing step S210 according to some embodiments of the present disclosure. FIG. 10B is a partial cross-sectional structural view taken along line A1-A2 in FIG. 10A. FIG. 10C is a partial cross-sectional structural view taken along line B1-B2 in FIG. 10A. For example, as shown in FIG. 10A to FIG. 10C, the semiconductor substrate 101 may be etched from the first initial surface F1 to form multiple active pillar rows. Each of the active pillar rows includes multiple active pillars 110 extending in a first direction Z (vertical direction Z) and arranged in a second direction X (horizontal direction X), the multiple active pillars 110 include a first active pillar 110 located in a first region Ra and a second active pillar 110 located in a second region Rb, the second region Rb is located on at least one side of the first region Ra in the second direction X, and the second direction X is perpendicular to the first direction Z. For example, in some embodiments, as shown in FIG. 10A to FIG. 10C, the multiple active pillars 110 in the active pillar row further include a third active pillar 110 located in a third region Rc, where the third region Rc is located between the first region Ra and the second region Rb. It may be understood that, as shown in FIG. 10A to FIG. 10C, step S210 may include a step as follows: A trench isolation structure 102 defining the multiple active pillars 110 is formed in the semiconductor substrate 101.

In the step of S220, a word line is formed in the semiconductor substrate.

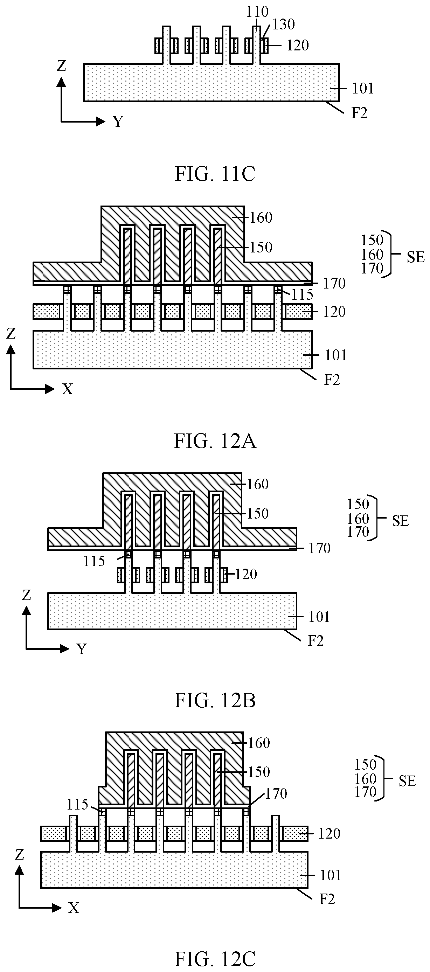

FIG. 11A is a partial planar structural view of a structure obtained by performing step S220 according to some embodiments of the present disclosure. FIG. 11B is a partial cross-sectional structural view taken along line A1-A2 in FIG. 11A. FIG. 11C is a partial cross-sectional structural view taken along line B1-B2 in FIG. 11A. For example, as shown in FIG. 11A to FIG. 11C, based on the structure shown in FIG. 10A to FIG. 10C, the word line 120 may be formed in the semiconductor substrate 101. The word line 120 extends in the first region Ra and the second region Rb in the second direction X, and is coupled to the multiple active pillars 110 in the active pillar row. For example, in some embodiments, as shown in FIG. 11A to FIG. 11C, the word line 120 further extends in the third region Rc in the second direction X.

For example, as shown in FIG. 11A to FIG. 11C, before the word line 120 is formed in the semiconductor substrate 101, a gate dielectric layer 130 may be formed first, and the gate dielectric layer 130 is located between each of the active pillars 110 and the subsequently formed word line 120.

It should be noted that, for brevity, the trench isolation structure 102 remained in the structure obtained according to step S220 is omitted in FIG. 11B and FIG. 11C.

In the step of S230, a data storage element is formed on the semiconductor substrate.

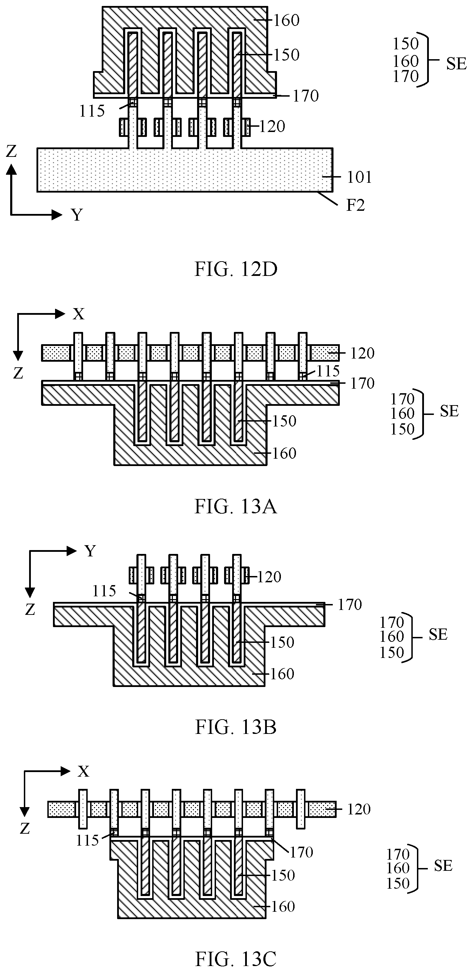

FIG. 12A and FIG. 12B are partial cross-sectional structural views of a structure obtained by performing step S230 according to some embodiments of the present disclosure. FIG. 12C and FIG. 12D are partial cross-sectional structural views of another structure obtained by performing step S230 according to some embodiments of the present disclosure. For example, as shown in FIG. 12A and FIG. 12B (or FIG. 12C and FIG. 12D), based on the structure shown in FIG. 11A to FIG. 11C, a data storage element SE may be formed on the semiconductor substrate 101. The data storage element SE is located on a first side of the first active pillar 110 in the first direction Z, and is coupled to the first active pillar 110. For example, as shown in FIG. 12A and FIG. 12B (or FIG. 12C and FIG. 12D), the data storage element SE may be a capacitor, which includes a first electrode 150, a second electrode 160, and a capacitor dielectric layer 170 disposed between the first electrode 150 and the second electrode 160. However, this embodiment of the present disclosure is not limited thereto. The data storage element SE may alternatively be a FeRAM (ferroelectric random access memory) storage element, a PCM (phase change memory) storage element, a MRAM (magnetic random access memory) storage element, or the like.

For example, in some embodiments, as shown in FIG. 12A and FIG. 12B (or FIG. 12C and FIG. 12D), based on the structure shown in FIG. 11A to FIG. 11C, a contact pad 115 may be formed first, the data storage element SE may be then formed, and the data storage element SE is coupled to a corresponding first active pillar 110a through the contact pad 115. For example, in some embodiments, as shown in FIG. 12A and FIG. 12B, the contact pad 115 may be formed on each of the first active pillar, the second active pillar, and the third active pillar. For example, in some other embodiments, as shown in FIG. 12C and FIG. 12D, the contact pad 115 may be formed on each of the first active pillar and the third active pillar, and the contact pad 115 may not be formed on the second active pillar. For example, in still some other embodiments, the contact pad 115 may be formed on only the first active pillar.

In the step of S240, the semiconductor substrate is thinned from the second initial surface until end portions that are of the multiple active pillars and that are away from the first initial surface are exposed.

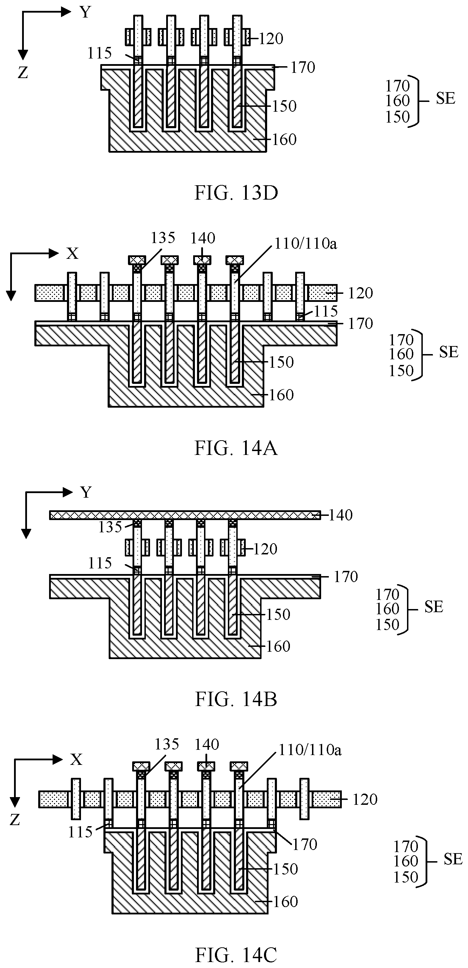

FIG. 13A and FIG. 13B are partial cross-sectional structural views of a structure obtained by performing step S240 according to some embodiments of the present disclosure. FIG. 13C and FIG. 13D are partial cross-sectional structural views of another structure obtained by performing step S240 according to some embodiments of the present disclosure. For example, as shown in FIG. 13A and FIG. 13B (or FIG. 13C and FIG. 13D), based on the structure shown in FIG. 12A and FIG. 12B (or FIG. 12C and FIG. 12D), the structure shown in FIG. 12A and FIG. 12B (or FIG. 12C and FIG. 12D) may be flipped, and the semiconductor substrate 101 is thinned from the second initial surface F2 until the end portions that are of the multiple active pillars 110 and that are away from the first initial surface F1 are exposed. For example, a surface that is of the thinned semiconductor substrate 101 and that is opposite to the first initial surface F1 serves as a second surface, and a surface that is of the thinned semiconductor substrate 101 and that is opposite to the second surface serves as a first surface.

In the step of S250, a bit line is formed in the first region.

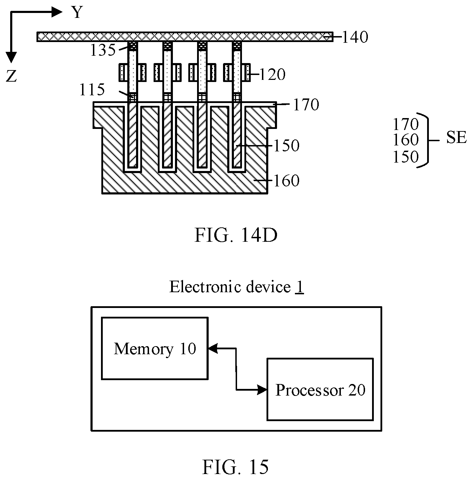

FIG. 14A and FIG. 14B are partial cross-sectional structural views of a structure obtained by performing step S250 according to some embodiments of the present disclosure. FIG. 14C and FIG. 14D are partial cross-sectional structural views of another structure obtained by performing step S250 according to some embodiments of the present disclosure. For example, as shown in FIG. 14A and FIG. 14B (or FIG. 14C and FIG. 14D), based on the structure shown in FIG. 13A and FIG. 13B (or FIG. 13C and FIG. 13D), the bit line 140 may be formed in the first region. The bit line 140 extends in the third direction Y, the bit line 140 is located on a second side that is of the first active pillar 110a in the first direction Z and that is opposite to the first side, the bit line 140 is coupled to the first active pillar 110a, the third direction Y is perpendicular to the first direction Z, and the third direction Y intersects with the second direction X. For example, the third direction Y may be perpendicular to the second direction X.

For example, in some embodiments, as shown in FIG. 14A and FIG. 14B (or FIG. 14C and FIG. 14D), based on the structure shown in FIG. 13A and FIG. 13B (or FIG. 13C and FIG. 13D), a bit line contact plug 135 may be first formed on the first active pillar 110a, and the bit line 140 is then formed. That is, the bit line 140 may be coupled to the first active pillar 110a through the bit line contact plug 135.

In the step of S260, a first contact plug is formed in the second region.

For example, in some embodiments, as shown in FIG. 4A, FIG. 4B, and FIG. 2D, based on the structure shown in FIG. 14A and FIG. 14B, a part of the second active pillar 110b and a part of a trench isolation structure (not shown in the figure) may be first etched from the second surface until the word line 120 is exposed; then a filling layer (not entirely shown in the figure) that covers the word line 120 is formed; and finally the first contact plug 125 is formed in the filling layer. The first contact plug 125 is coupled to the word line 120, and an orthographic projection of the first contact plug 125 in the first direction Z overlaps with an orthographic projection of the second active pillar 110b in the first direction Z. It may be understood that the size of the remaining second active pillar 110b in the first direction Z is less than the size of the first active pillar 110a in the first direction Z.

For example, in some examples, as shown in FIG. 4B, the second active pillar 110b may be over-etched, so that an exposed surface (a bottom surface in FIG. 4B) of the second active pillar 110b is lower than an exposed surface (a bottom surface in FIG. 4B) of the word line 120. Correspondingly, after the first contact plug 125 is formed, a part that is of the filling layer and that is located on the bottom surface of the second active pillar 110b may serve as an isolation portion 180, and the isolation portion 180 located between the first contact plug 125 and the second active pillar 110b may insulate the first contact plug 125 from the second active pillar 110b. For example, in some other examples, referring to the case shown in FIG. 2C, the second active pillar 110b may be over-etched, and the subsequently formed first contact plug 125 contacts the second active pillar 110b and contacts a part of a side surface of the word line 120. For example, in some other examples, referring to the case shown in FIG. 2C, the second active pillar 110b does not need to be over-etched, and the subsequently formed first contact plug 125 contacts the second active pillar 110b. It may be understood that, in some other examples, a case in FIG. 3B or FIG. 3C in which the first contact plug 125, the second active pillar 110b, and the isolation portion 180 are disposed opposite to each other may be implemented.

For example, in some other embodiments, as shown in FIG. 5A to FIG. 5C, based on the structure shown in FIG. 14A and FIG. 14B, the structure shown in FIG. 14A and FIG. 14B may be flipped, and a part of the second active pillar 110b and a part of a dielectric layer (not shown in the figure) surrounding the second active pillar 110b are etched from the first surface until the word line 120 is exposed; then the filling layer (not entirely shown in the figure) that covers the word line 120 is formed; and finally the first contact plug 125 is formed in the filling layer. The first contact plug 125 is coupled to the word line 120, and an orthographic projection of the first contact plug 125 in the first direction Z overlaps with an orthographic projection of the second active pillar 110b in the first direction Z.

For example, in some examples, as shown in FIG. 5B, the second active pillar 110b may be over-etched, so that an exposed surface (a top surface in FIG. 5B) of the second active pillar 110b is lower than an exposed surface (a top surface in FIG. 5B) of the word line 120. Correspondingly, after the first contact plug 125 is formed, a part that is of the filling layer and that is located on the top surface of the second active pillar 110b may serve as an isolation portion 180, and the isolation portion 180 located between the first contact plug 125 and the second active pillar 110b may insulate the first contact plug 125 from the second active pillar 110b. It may be understood that, in some other examples, a case (the first contact plug 125 is disposed above the second active pillar 110b) similar to a case in any one of FIG. 2B, FIG. 2C, FIG. 3B, and FIG. 3C in which the first contact plug 125, the second active pillar 110b, and the isolation portion 180 are disposed opposite to each other may be implemented.

It may be understood that the second contact plug 145 coupled to the bit line 140 may be formed while the first contact plug 125 is formed.

In the step of S300, a second semiconductor structure is provided.

For example, in some embodiments, the second semiconductor structure 200 shown in FIG. 6B and FIG. 6C (or FIG. 7B and FIG. 7C) may be provided. The second semiconductor structure 200 may include a peripheral circuit (the peripheral circuit is shown as multiple transistors 210).

In the step of S400, the first semiconductor structure is bonded to the second semiconductor structure.

For example, in some embodiments, the first semiconductor structure 100 may be bonded to the second semiconductor structure 200 through a hybrid bonding (hybrid bonding) technology or the like.

For example, in some embodiments, as shown in FIG. 6A to FIG. 6C, the first semiconductor structure 100 (with the structures shown in FIG. 4A, FIG. 4B, and FIG. 2D as examples) may be bonded to the second semiconductor structure 200, so that the word line 120 is coupled to the peripheral circuit through the first contact plug 125, and the bit line 140 is coupled to the peripheral circuit through the second contact plug 145. The second semiconductor structure 200 is disposed on the second side that is of the first active pillar 110 in the first direction Z and that is opposite to the first side. Herein, the first semiconductor structure 100 and the second semiconductor structure 200 are bonded in a form of "Back to Face" (Back to Face) (that is, a back surface of the first semiconductor structure is opposite to a front surface of the second semiconductor structure).

For example, in some other embodiments, as shown in FIG. 7A to FIG. 7C, the first semiconductor structure 100 (with the structure shown in FIG. 5A to FIG. 5C as an example) may be bonded to the second semiconductor structure 200, so that the word line 120 is coupled to the peripheral circuit through the first contact plug 125, and the bit line 140 is coupled to the peripheral circuit through the second contact plug 145. The second semiconductor structure 200 is disposed on a side that is of the data storage element SE in the first direction Z and that is away from the first active pillar 110a. Herein, the first semiconductor structure 100 and the second semiconductor structure 200 are bonded in a form of "Face to Face" (Face to Face) (that is, a front surface of the first semiconductor structure is opposite to a front surface of the second semiconductor structure).

For example, as shown in FIG. 6B and FIG. 6C (or FIG. 7B and FIG. 7C), the first semiconductor structure 100 may further include a first interconnection layer 190, the second semiconductor structure 200 may further include a second interconnection layer 220, and the first interconnection layer 190 and the second interconnection layer 220 are bonded through a bonding interface 300, to implement bonding between the first semiconductor structure 100 and the second semiconductor structure 200.

It should be noted that, for details not described in the embodiment of the manufacturing method of the present disclosure, refer to related descriptions of the embodiment of the foregoing memory. Details are not described herein again.

At least some embodiments of the present disclosure further provide an electronic device. FIG. 15 is a schematic block diagram of a structure of an electronic device according to some embodiments of the present disclosure. As shown in FIG. 15, the electronic device 1 includes a processor 20 and a memory 10 that are coupled to each other. The memory 10 is the memory provided in any one of the foregoing embodiments.

For example, the processor 20 may include but is not limited to a central processing unit (CPU), a graphics processing unit (GPU), or the like. The memory 10 may be configured to store data to be processed by the processor 20 and/or data processed by the processor.

For example, the electronic device 1 includes but is not limited to a mobile phone, a tablet computer, a smart wristband, a wearable electronic device, a virtual reality device, an augmented reality device, an on-board device, a server, or a workstation.

The foregoing descriptions are merely specific implementations of the present disclosure, but are not intended to limit the protection scope of the present disclosure. Any variation or replacement readily figured out by a person skilled in the art within the technical scope disclosed in the present disclosure shall fall within the protection scope of the present disclosure. Therefore, the protection scope of the present disclosure shall be subject to the protection scope of the claims.

## Claims

1. A memory, comprising a first semiconductor structure, the first semiconductor structure comprising:
an active pillar row, comprising a plurality of active pillars (110) extending in a first direction (Z) and arranged in a second direction (X), the plurality of active pillars comprising a first active pillar (110a) located in a first region (Ra) and a second active pillar (110b) located in a second region (Rb), wherein the second region is located on at least one side of the first region in the second direction, and the second direction is perpendicular to the first direction;
a word line (120), extending in the first region and the second region in the second direction, and coupled to the plurality of active pillars in the active pillar row;
a data storage element (SE), located on a first side of the first active pillar in the first direction, and coupled to the first active pillar; and
a first contact plug (125), located in the second region and coupled to the word line, wherein an orthographic projection of the first contact plug in the first direction overlaps with an orthographic projection of the second active pillar in the first direction.

2. The memory according to claim 1, wherein a size of the second active pillar in the first direction is less than a size of the first active pillar in the first direction.

3. The memory according to claim 1, wherein a size of the second active pillar in the second direction is equal to a size of the first active pillar in the second direction.

4. The memory according to claim 2 or 3, wherein a top surface of the second active pillar is substantially flush with a top surface of the first active pillar, or a bottom surface of the second active pillar is substantially flush with a bottom surface of the first active pillar.

5. The memory according to any one of claims 1 to 3, wherein a plurality of first contact plugs are arranged in the second region in a staggered manner.

6. The memory according to any one of claims 1 to 5, wherein the first semiconductor structure further comprises:
a bit line (140), extending in the first region in a third direction (Y), located on a second side that is of the first active pillar in the first direction and that is opposite to the first side, and coupled to the first active pillar, wherein the third direction is perpendicular to the first direction and intersects with the second direction.

7. The memory according to claim 4, wherein the first semiconductor structure further comprises:
a second contact plug (145), coupled to the bit line.

8. The memory according to any one of claims 1 to 7, further comprising:
a second semiconductor structure (200), comprising a peripheral circuit, and bonded to the first semiconductor structure, wherein
the word line is coupled to the peripheral circuit through the first contact plug.

9. The memory according to claim 8, wherein the second semiconductor structure is located on the second side of the first active pillar in the first direction.

10. A manufacturing method for a memory, comprising:
providing a semiconductor substrate (101), the semiconductor substrate having a first initial surface (F1) and a second initial surface (F2) that are opposite to each other;
forming a first semiconductor structure (100) based on the semiconductor substrate,
the forming a first semiconductor structure based on the semiconductor substrate comprising:
etching the semiconductor substrate from the first initial surface to form an active pillar row, the active pillar row comprising a plurality of active pillars (110) extending in a first direction (Z) and arranged in a second direction (X), the plurality of active pillars comprising a first active pillar (110a) located in a first region (Ra) and a second active pillar (110b) located in a second region (Rb), wherein the second region is located on at least one side of the first region in the second direction, and the second direction is perpendicular to the first direction;
forming a word line (120) in the semiconductor substrate, the word line extending in the first region and the second region in the second direction, and being coupled to the plurality of active pillars in the active pillar row;
forming a data storage element (SE) on the semiconductor substrate, the data storage element being located on a first side of the first active pillar in the first direction, and being coupled to the first active pillar;
thinning the semiconductor substrate from the second initial surface until end portions that are of the plurality of active pillars and that are away from the first initial surface are exposed; and
forming a first contact plug (125) in the second region, the first contact plug being coupled to the word line, wherein an orthographic projection of the first contact plug in the first direction overlaps with an orthographic projection of the second active pillar in the first direction.

11. The manufacturing method according to claim 10, wherein the etching the semiconductor substrate from the first initial surface to form an active pillar row comprises: forming a trench isolation structure (102) defining the plurality of active pillars in the semiconductor substrate; and
adopting a surface that is of the thinned semiconductor substrate and that is opposite to the first initial surface as a second surface; and
the forming a first contact plug in the second region comprises:
etching a part of the second active pillar and a part of the trench isolation structure from the second surface until the word line is exposed;
forming a filling layer that covers the word line; and
forming the first contact plug in the filling layer.

12. The manufacturing method according to claim 11, wherein a size of the remaining second active pillar in the first direction is less than a size of the first active pillar in the first direction.

13. The manufacturing method according to claim 11 or 12, wherein before the forming the first contact plug in the filling layer, the forming a first semiconductor structure based on the semiconductor substrate further comprises:
forming a bit line (140) in the first region, the bit line extending in a third direction (Y), being located on a second side that is of the first active pillar in the first direction and that is opposite to the first side, and being coupled to the first active pillar, wherein the third direction is perpendicular to the first direction and intersects with the second direction.

14. The manufacturing method according to any one of claims 10 to 13, further comprising:
providing a second semiconductor structure (200), the second semiconductor structure comprising a peripheral circuit; and
bonding the first semiconductor structure to the second semiconductor structure, so that the word line is coupled to the peripheral circuit through the first contact plug, the second semiconductor structure being disposed on the second side that is of the first active pillar in the first direction and that is opposite to the first side.

15. An electronic device (1), comprising:
a processor (20); and
the memory (10) according to any one of claims 1 to 9, the memory being coupled to the processor.
